Europäisches Patentamt

European Patent Office

Office européen des brevets

(19)

(11) Publication number: **0 072 226**
**B1**

(12) # EUROPEAN PATENT SPECIFICATION

(45) Date of publication of patent specification: **29.05.85**

(51) Int. Cl.⁴: **C 30 B 25/14**

(21) Application number: **82304170.2**

(22) Date of filing: **06.08.82**

(54) **Vapor phase deposition of semiconductor material.**

(30) Priority: **08.08.81 JP 124515/81**

(43) Date of publication of application:
**16.02.83 Bulletin 83/07**

(45) Publication of the grant of the patent:
**29.05.85 Bulletin 85/22**

(84) Designated Contracting States:
**DE FR GB**

(56) References cited:
**DE-A-2 743 909**

**IBM TECHNICAL DISCLOSURE BULLETIN, vol.
15, no. 11, April 1973, Seiten 3550-3551, New
York, USA R.L. BRATTER et al.: "Insuring
consistent doping levels of epitaxial layers
grown on batches of wafers"**

**IBM TECHNICAL DISCLOSURE BULLETIN, vol.
13, no. 12, May 1971, page 3887, New York,
USA L.M. ELIJAH : "Improving resistivity and
thickness uniformity of epitaxial deposits"**

(73) Proprietor: **FUJITSU LIMITED
1015, Kamikodanaka Nakahara-ku
Kawasaki-shi Kanagawa 211 (JP)**

(72) Inventor: **Furumura, Yuji
1580, Shukugawara Tama-ku
Kawasaki-shi Kanagawa 214 (JP)**
Inventor: **Nishizawa, Takeshi
Azami-so, 262, Imainakamachi Nakahara-ku
Kawasaki-shi Kanagawa 211 (JP)**

(74) Representative: **Fane, Christopher Robin King
et al
HASELTINE LAKE & CO. Hazlitt House 28
Southampton Buildings Chancery Lane
London, WC2A 1AT (GB)**

Courier Press, Leamington Spa, England.

## Description

This invention relates to vapor phase deposition of semiconductor material, and is more particularly concerned with such vapor phase deposition under low pressure in a "horizontal" type reaction tube.

Many types of vapor phase deposition systems such as horizontal, vertical and barrel types, are known in the art. Vertical and barrel type systems, however, are relatively poor in productivity since only a small number of wafers can be loaded therein. Horizontal type systems, i.e. systems having a horizontal reaction tube, are usually preferable since a large number of wafers can be loaded therein by arranging them in the tube parallel to each other and transverse to the longitudinal axis of the tube.

Horizontal type systems in which wafers are arranged in parallel and transversely to the axis of the reaction tube (henceforth called "horizontal type systems"), however, cannot be easily applied to epitaxial growth of impurity-doped single crystalline film since such applications require strict film thickness and specific resistivity, and other conditions.

In the reaction tube of such a previously proposed system, for example, silicon source and impurity gases progressively decrease in concentration from the inlet toward the outlet due to their consumption. This can cause a corresponding progressive decrease in the thickness and doping concentration of deposited film. This in turn causes a corresponding increase in the specific resistivity of the film. Provision of a temperature gradient increasing from the inlet toward the outlet along the axis of the tube can give thickness uniformity of the deposited films in spite of the progressive decrease in the concentration of the reaction gas. However, it can also cause reduction in impurity concentration from the inlet toward the outlet. Thus, variations may occur in film thicknesses and/or impurity concentrations, i.e. specific resistivities, so that only a small number of the products meet the strict requirements on thickness and specific resistivity.

It is accordingly desirable to provide a horizontal type vapor phase deposition system which can produce a larger number of epitaxial films, with improved uniformity of film thickness and impurity concentration.

According to one aspect of the present invention there is provided a method of vapor phase deposition for growing a semiconductor layer on a plurality of wafers, wherein a main gas containing a reaction gas and an impurity gas flows in a first direction through a deposition region in a reaction tube, said plurality of wafers are so arranged in said deposition region that each of the major surfaces of said plurality of wafers is parallel to the others and is transverse to a longitudinal axis of said reaction tube, and an auxiliary gas containing an impurity gas is introduced into said reaction tube at a position downstream, with respect to the main gas flow, of said deposition region in such a manner that said impurity gas of said auxiliary gas diffuses in a second direction opposite to said first direction along an inner wall of said reaction tube.

It is surprisingly found that a gas fed to a reaction tube near a discharge port can diffuse toward a gas inlet along an inner stagnant layer in spite of gas suction toward the discharge port and the gas flow from the gas inlet toward the discharge port. Such reverse diffusion occurs more easily at low pressure. The reverse diffusion can compensate for the decreased gas concentration when the decreased gas fraction is small in comparison with the other gas fractions. These conditions are readily satisfied in effecting vapor phase epitaxial growth under low pressure. It is also preferred that an impurity gas be diffused reversely since its concentration is usually low.

Further, it is desirable to guide the auxiliary gas along the inner wall of the reaction tube since the velocity of the main gas flow from the gas inlet toward the gas outlet in the reaction tube is low there. Such guidance is preferably assisted by use of an inner tube, inserted inside the reaction tube, having openings distributed along the axis of the tube.

Another aspect of the present invention provides an apparatus for vapor phase deposition of a semi-conductor film on a plurality of wafers comprising: a) a reaction tube having a deposition region in which said plurality of wafers are so arranged that each of the major surfaces of said plurality of wafers is parallel to the others and is transverse to a longitudinal axis of said reaction tube; b) means for heating said wafers; c) means for flowing in a first direction a main gas through said deposition region in said tube; and d) means arranged downstream, with respect to the main gas flow, of said deposition region for introducing an auxiliary gas into said reaction tube in such a manner that said auxiliary gas diffuses along an inner wall of said reaction tube in a second direction opposite to said first direction.

It is preferred that the apparatus further comprise means for guiding said auxiliary gas along the inner wall of said reaction tube. The guiding means may be a tubular member extending inside the reaction tube in said second direction.

It is also preferred that the reaction tube comprise an outer tube and an inner tube surrounded by the outer tube and removable from the reaction tube so that matter deposited on the inner wall of the inner tube is accessible for cleaning. It is further preferred that the inner tube have a plurality of openings distributed along the longitudinal axis of the inner tube, and the inner tube and the outer tube form therebetween an annular space into which the auxiliary gas is fed. The openings provided on the inner tube may be of a shape elongated along the side of the inner tube and may be distributed staggered along the axis of the inner tube. Alternatively, a plurality of inner tubes may be arranged along the axis of the reaction tube with the spaces therebetween defining annular openings.

Reference will now be made, by way of example, to the accompanying drawings, wherein:

FIGURE 1 shows a schematic axial sectional view of apparatus used in a first embodiment of the present invention;

FIGURE 2 shows a sectional view, to a larger scale, of part of the apparatus of Figure 1;

FIGURE 3 shows graphs of thickness and specific resistivity of deposited film, obtained by the apparatus of Figure 1, against position in a reaction tube;

FIGURE 4 shows a schematic axial sectional view of apparatus used in a second embodiment of the present invention;

FIGURE 5 shows a perspective view of part of the apparatus of Figure 4;

FIGURE 6 shows graphs of thickness and specific resistivity of deposited films, obtained by the apparatus in Figure 4, against position in a reaction tube; and

FIGURE 7 is a graph of film thickness against position in a reaction tube in an experiment relating to the present invention.

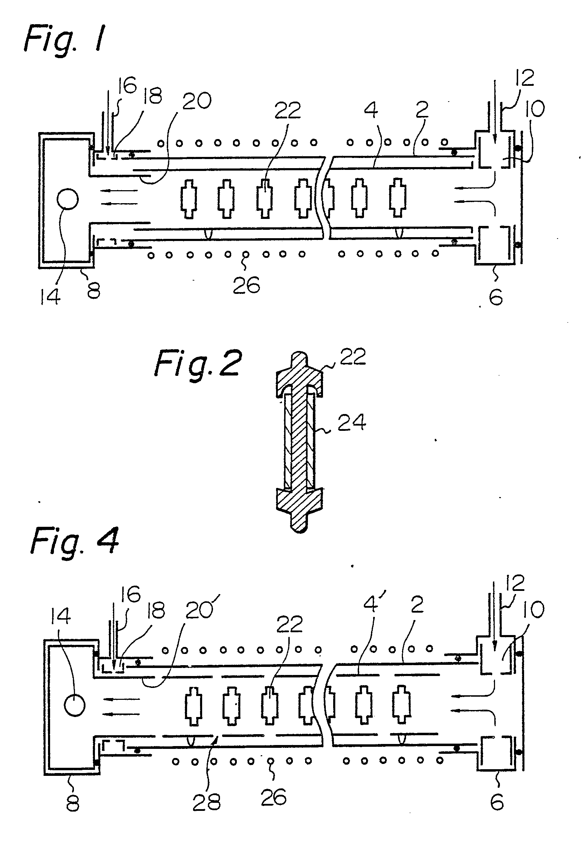

An embodiment of the present invention was tested by using a vapor phase deposition apparatus as illustrated in Figure 1. The apparatus in Figure 1 comprises a reaction tube, comprising 230 mm$\emptyset$ quartz tube 2 and 200 mm$\emptyset$ quartz inner tube 4 concentrically inserted therein, stainless steel inlet member 6, and stainless steel outlet member 8. Inlet member 6 has annular chamber 10 having at least three 10 mm$\emptyset$-bores distributed in the inner wall thereof. Chamber 10 communicates with inlet pipe 12. Outlet member 8 has discharge port 14. The apparatus further comprises, at the end of reaction tube 2 near outlet port 14, auxiliary gas inlet 16 and an annular chamber 18 having twenty 5 mm$\emptyset$-bores distributed in the inner wall thereof. Inside annular chamber 18 there is provided annular guide member 20 having a diameter of 180 mm for guiding auxiliary gas along the inner tube 4 adjacent to its inner boundary surface.

Twenty-one susceptors 22, each holding two silicon wafers 24 as shown in Fig. 2, were inserted in inner tube 4. These susceptors 22 were equally spaced over a 600 mm distance. Susceptors 22 were successively numbered from the inlet side (No. 1) to the discharge side (No. 21). The distance from susceptor No. 21 to annular guide member 20 was 450 mm. Silicon wafers 24 were heated by susceptor 22 inductively heated by work coil 26.

In operation, a gas mixture of dichlorosilane ($SiH_2Cl_2$), hydrogen ($H_2$) and phosphine ($PH_3$) was fed through inlet pipe 12 and annular chamber 10 into inner tube 4 and evacuated through discharge port 14. The gas feeding rates were 5 l/min for $H_2$, 500 cm$^3$/min for $SiH_2Cl_2$, and 20 cm$^3$/min for $H_2$ containing 1 ppm-$PH_3$. The pressure inside the tube was 1.0 Torr. The temperatures of silicon wafers 24 were controlled to increase proportionally from 1025°C at susceptor No. 1 to 1050°C at susceptor No. 21. An auxiliary gas consisting of

100 ppm-$PH_3$ in $H_2$ was fed through auxiliary gas inlet 16 and annular chamber 18 at a gas feeding rate of 12 cm$^3$/min for $H_2$ containing $PH_3$. In this case the end of the annular space formed between tube 2 and inner tube 4 near inlet member 6 was closed so as not to allow auxiliary gas to flow therethrough and not to allow main gas to enter therein.

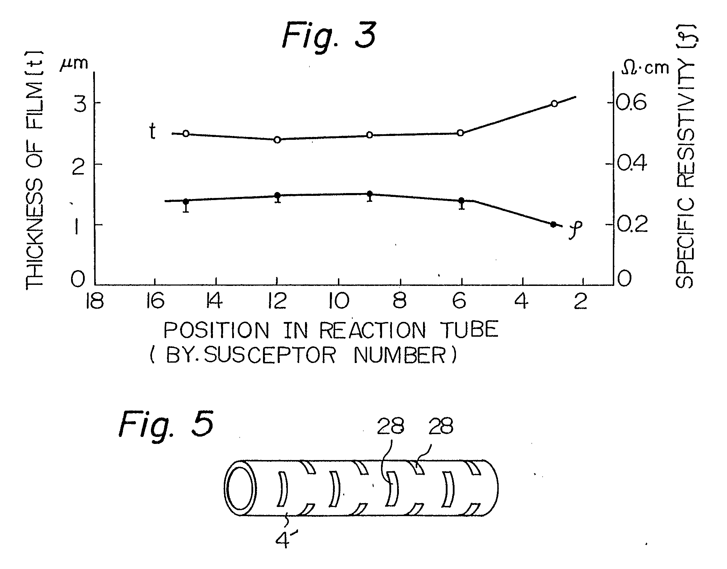

The measured thicknesses and specific resistivities of epitaxial grown silicon films on silicon wafers 24 resulting from the above operation are as shown in Fig. 3. Figure 3 shows a uniformity of thickness of the epitaxial silicon films, which may be attributed to the above-described temperature control. Figure 3 also illustrates a leveling effect on specific resistivity attained when feeding an auxiliary $PH_3$ gas. If the auxiliary $PH_3$ gas were not fed, the specific resistivity of the epitaxial silicon film would progressively increase from the lower number susceptors to the higher number susceptors. A very weak peak in the specific resistivity curve can be seen in Fig. 3. This peak, however, can be lowered by increasing the evacuating rate out of the reaction tube.

Acceptable tolerances for thickness and specific resistivity of epitaxial silicon films in most applications are ±5% and ±7%, respectively. The above operation produced 14 wafers or films having a 150 mm diameter and satisfying the above requirements. In contrast, vertical, horizontal, or barrel type vapor phase deposition systems in the prior art usually produce only a maximum of about 10, 10, or 12 such wafers, respectively.

Next, an embodiment of the present invention was investigated by using a vapor phase deposition apparatus as shown in Fig. 4. This apparatus was similar to the apparatus used in the above-described test, except for the following:

inner tube 4' has openings 28 distributed along the axis of inner tube 4';

annular guide member 20' has the same diameter as inner tube 4' to guide auxiliary gas into the space formed between tube 2 and inner tube 4'; and

the end of the above space between tubes 2 and 4' near inlet member 6 is open, not closed completely.

The shape and arrangement of openings 28 in inner tube 4' in this work are illustrated in Fig. 5. The openings are 2 mm wide and extend 100 mm around the wall of inner tube 4'. A plurality of pairs of openings are distributed at 100 mm intervals and staggered along the axis of inner tube 4', each pair's openings directly opposite each other.

In operation, $SiH_2Cl_2$, $H_2$, and $H_2$ containing 1 ppm-$PH_3$ were fed at rates of 500 cm$^3$/min, 5 l/min, and 18 cm$^3$/min as the main gas and $H_2$ containing 10 ppm-$PH_3$ was fed at a rate of 16 cm$^3$/min as the auxiliary gas. The pressure inside inner tube 4' was 1.0 Torr. The other conditions were the same as in the above-described operation.

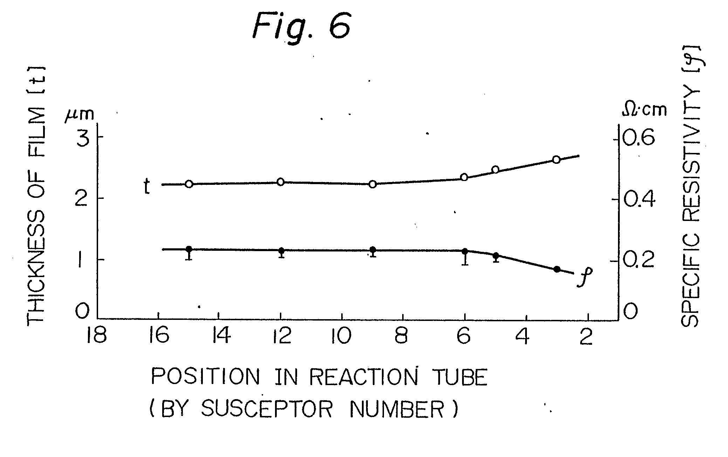

The results are shown in Fig. 6. Both the specific resistivities and thicknesses of epitaxial silicon films are desirably uniform. About 18 to 20 150-mm diameter films have passed the above-mentioned criteria in this operation. An experiment was carried out as below to demonstrate diffusion action of the auxiliary gas. The apparatus as shown in Fig. 4 was used. $SiH_2Cl_2$ and $H_2$ were fed at rates of 450 $cm^3$/min and 5 l/min respectively through auxiliary inlet pipe 16 into the reaction tube and were evacuated out of discharge port 14. Inlet pipe 12 was closed. The pressure inside the reaction tube was 1.0 Torr. The susceptor arrangement and temperature profile in the reaction tube were similar to those in the above described operations.

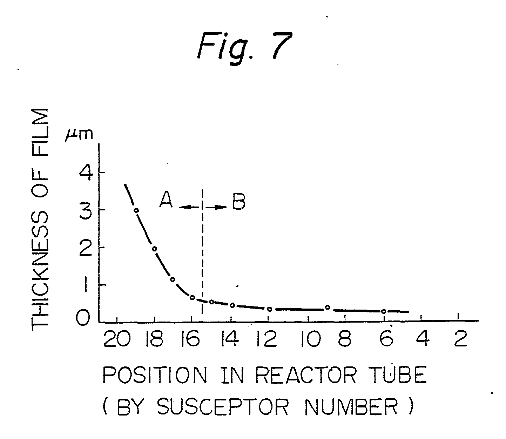

The resultant thicknesses of silicon films are shown in Fig. 7. If the thickness of a deposited film can be taken to be proportional to the amount of a gas flowing there, Fig. 7 shows that viscous flow gas A flows toward discharge port 14 without spreading beyond a rear part or a part near discharge port 14 of the reaction tube and that diffusion flow gas B reaches a front part or a part near inlet member 6 of the reaction tube with monotonic decrease in the amount of the gas. It may be understood that an auxiliary impurity gas, such as $PH_3$ in the operation described above, flows with a concentration profile similar or related to the curve in Fig. 7 and contributes to deposition or doping. It is therefore understood that epitaxial films are doped desirably even at the rear part of the reaction tube by the presence of the auxiliary gas.

It should be noted that the auxiliary gas should be fed through relatively large bores or openings into the reaction tube so that the gas entering into the reaction tube can diffuse along the inner wall of the tube toward a main gas inlet. The gas should not be injected through a nozzle or nozzles to flow as a viscous flow. Clearly, the impurity concentration in a deposited film can be controlled by changing the concentration of the main and auxiliary impurity gases.

## Claims

1. A vapor phase deposition method of growing semi-conductor layers on a plurality of wafers, wherein a main gas containing a reaction gas and an impurity gas flows in a first direction along a reaction tube, through a deposition region therein, said plurality of wafers being so arranged in said deposition region that each of their major faces is parallel to the others and is transverse to a longitudinal axis of said reaction tube, characterised in that an auxiliary gas comprising an impurity gas is introduced into said reaction tube at a position downstream, with respect to the main gas flow, of said deposition region in such a manner that said impurity gas of said auxiliary gas diffuses along the reaction tube, in a direction opposite to said first direction, adjacent to inner boundary surface regions of said reaction tube.

2. A method according to claim 1, wherein said impurity gas of the auxiliary gas diffusing along the inner boundary surface of the reaction tube can pass to said plurality of wafers through openings of an inner tube which is positioned in said reaction tube.

3. A method according to claim 1 or 2, wherein said auxiliary gas consists only of said impurity gas.

4. An apparatus for effecting vapor phase deposition of semiconductor layers on a plurality of wafers, comprising:
a reaction tube; means for mounting the wafers in a deposition region in the tube, so that each of the major faces of the wafers is parallel to the others and is transverse to a longitudinal axis of the tube, and heating the wafers whilst mounted in the said deposition region; and means for causing a main gas containing an impurity gas to flow, in a first direction along the reaction tube, through said deposition region in the tube; characterised by means arranged for introducing an auxiliary gas comprising an impurity gas into said reaction tube at a position downstream, with respect to the main gas flow, of said deposition region in such a manner that said impurity gas of said auxiliary gas diffuses along the reaction tube, adjacent to inner boundary surface regions thereof, in a direction opposite to said first direction.

5. An apparatus as claimed in claim 4, further comprising means for guiding said auxiliary gas along the inner boundary surface of said reaction tube.

6. An apparatus as claimed in claim 5, wherein the guiding means comprise a tubular member extending inside said reaction tube in said opposite direction.

7. An apparatus as claimed in claim 4, wherein said reaction tube comprises an outer tube having therewithin an inner tubular member surrounded by said outer tube.

8. An apparatus as claimed in claim 6 or 7, wherein said tubular member is formed with a plurality of openings distributed therealong, the apparatus being such that when it is in use said auxiliary gas is introduced into an annular space defined between the reaction tube and said tubular member.

## Patentansprüche

1. Verfahren zur Gasabscheidung von Halbleitermaterial zum Aufwachsen von Halbleiterschichten auf einer Vielzahl von Wafern, bei welchem ein Hauptgas, welches ein Reaktionsgas und ein Verunreinigungsgas enthält, in eine erste Richtung längs einem Reaktionsrohr strömt, durch einen Abscheidungsbereich in diesem, wobei die genannte Anzahl von Wafern so in dem Abscheidungsbereich angeordnet ist, daß jede ihrer Hauptoberflächen parallel zu den anderen ist und daß sie quer zu einer Längsachse des genannten Reaktionsrohres angeordnet sind, dadurch gekennzeichnet, daß ein Hilfsgas, welches ein Verunreinigungsgas enthält, in das genannte Reaktionsrohr an einer Position stromabwärts von dem genannten Abscheidungsbereich, in Bezug auf den Hauptgasstrom, so angeordnet ist, daß das genannte Verunreinigungsgas des Hilfsgases längs dem Reaktionsrohr neben den inneren Grenzoberflächenbereichen des genannten Reaktionsrohres in einer Richtung entgegengesetzt zu der erstgenannten Richtung diffundiert.

2. Verfahren nach Anspruch 1, bei welchem das genannte Verunreinigungsgas des Hilfsgases, welches längs der inneren Grenzoberfläche des Reaktionsrohres diffundiert, zu der genannten Anzahl von Wafern durch Öffnungen eines inneren Rohres, welches in dem genannten Reaktionsrohr angeordnet ist, hindurchgelangen kann.

3. Verfahren nach Anspruch 1 oder 2, bei welchem das genannte Hilfsgas lediglich aus dem genannten Verunreinigungsgas besteht.

4. Vorrichtung zur Bewirkung der Gasphasenabscheidung von Halbleiterschichten auf einer Anzahl von Wafern, mit:

einem Reaktionsrohr Einrichtungen zur Montage der Wafer in dem Abscheidungsbereich in dem Rohr, so daß jede der Hauptoberflächen der Wafer parallel zu den anderen und quer zu der Längsachse des Rohres ist und zur Erhitzung der Wafer, während sie in dem genannten Abscheidungsbereich angeordnet sind; und Einrichtungen, die bewirken, daß ein Hauptgasstrom, der ein Verunreinigungsgas enthält, in eine erste Richtung längs dem Reaktionsrohr durch den genannten Abscheidungsbereich in dem Rohr strömt; gekennzeichnet durch Einrichtungen, welche zur Einführung eines Hilfsgases, das ein Verunreinigungsgas enthält, in das genannte Reaktionsrohr an einer Position stromabwärts von dem Abscheidungsbereich, in Bezug auf den Hauptgasstrom, so angeordnet sind, daß das genannte Verunreinigungsgas des genannten Hilfsgases längs dem Reaktionsrohr, neben inneren Grenzoberflächenbereichen desselben, in eine Richtung entgegengesetzt zur genannten ersten Richtung, diffundiert.

5. Vorrichtung nach Anspruch 4, gekennzeichnet durch Einrichtungen zur Führung des genannten Hilfsgases längs der inneren Grenzoberfläche des genannten Reaktionsrohres.

6. Vorrichtung nach Anspruch 5, bei welcher die Führungseinrichtung ein rohrförmiges Teil umfaßt, das sich innerhalb des genannten Reaktionsrohres in die genannte entgegengesetzte Richtung erstreckt.

7. Vorrichtung nach Anspruch 4, bei welcher das genannte Reaktionsrohr ein äußeres Rohr umfaßt, welches ein inneres rohrförmiges Teil enthält, das von dem genannten äußeren Rohr umgeben ist.

8. Vorrichtung nach Anspruch 6 oder 7, bei welcher das genannte rohrförmige Teil eine Vielzahl von Öffnungen aufweist, die über seine Länge verteilt sind, und die Vorrichtung so ausgebildet ist, daß im Betrieb das genannte Hilfsgas in einen ringförmigen Raum eingeführt wird, der zwischen dem Reaktionsrohr und dem genannten rohrförmigen Teil definiert ist.

**Revendications**

1. Procédé de dépôt en phase vapeur de croissance de couches semi-conductrices sur plusieurs plaquettes, dans lequel un gaz principal contenant un gaz de réaction et un gaz d'impuretés circulent dans un premier sens le long d'un tube à réaction, en passant par une région de dépôt qui s'y trouve, lesdites plusieurs plaquettes étant disposées dans ladite région de dépôt de manière que chacune de leurs faces majeures soient parallèles aux autres et perpendiculaires à un axe longitudinal dudit tube à réaction, caractérisé en ce qu'un gaz auxiliaire consistant en un gaz d'impuretés est introduit dans ledit tube à réaction dans une position en aval de ladite région de dépôt, par rapport audit écoulement de gaz principal, de manière que ledit gaz d'impuretés dudit gaz auxiliaire diffuse le long du tube à réaction dans un sens opposé audit premier sens, contre les régions de surface limite intérieures dudit tube à réaction.

2. Procédé selon la revendication 1, dans lequel ledit gaz d'impuretés dudit gaz auxiliaire diffusant le long de la surface limite intérieure du tube à réaction peut passer vers lesdites plusieurs plaquettes par des ouvertures dans un tube intérieur qui est positionné dans ledit tube à réaction.

3. Procédé selon la revendication 1 ou 2, dans lequel ledit gaz auxiliaire consiste uniquement en ledit gaz d'impuretés.

4. Appareil destiné à effectuer un dépôt en phase vapeur de couches semi-conductrices sur plusieurs plaquettes, comportant: un tube à réaction; un dispositif pour monter les plaquettes dans une région de dépôt dans le tube de manière que chacune des faces majeures des plaquettes soit parallèle aux autres et soit perpendiculaire à un axe longitudinal du tube, et chauffant les plaquettes pendant qu'elles sont montées dans ladite région de dépôt; et un dispositif qui fait circuler un gaz principal contenant un gaz d'impuretés, dans un premier sens, le long du tube à réaction, en passant par ladite région de dépôt dans le tube; caractérisé par un dispositif agencé pour introduire un gaz auxiliaire consistant en un gaz d'impuretés dans le tube à réaction dans une position en aval de ladite région de dépôt par rapport au courant de gaz principal, de manière que ledit gaz d'impuretés dudit gaz auxiliaire diffuse le long du tube à réaction, contre des régions de surface limite intérieures, dans un sens opposé audit premier sens.

5. Appareil selon la revendication 4, comprenant en outre un dispositif pour guider ledit gaz auxiliaire le long de la surface limite intérieure dudit tube à réaction.

6. Appareil selon la revendication 5, dans lequel le dispositif de guidage consiste en une pièce tubulaire disposée à l'intérieur dudit tube à réaction dans ledit sens opposé.

7. Appareil selon la revendication 4, dans lequel ledit tube à réaction comporte un tube extérieur

9

avec à l'intérieur une pièce tubulaire extérieure entourée par ledit tube extérieur.

8. Appareil selon la revendication 6 ou 7, dans lequel ladite pièce tubulaire est formée avec plusieurs ouvertures distribuées sur sa longueur, l'appareil étant tel que lorsqu'il est utilisé, ledit gaz auxiliaire est introduit dans un espace annulaire défini entre le tube à réaction et ladite pièce tubulaire.

*Fig. 1*

*Fig. 2*

*Fig. 4*

*Fig. 3*

THICKNESS OF FILM [t]

SPECIFIC RESISTIVITY [$\rho$]

POSITION IN REACTION TUBE
( BY. SUSCEPTOR NUMBER )

*Fig. 5*

0 072 226

Fig. 6

# Fig. 7

THICKNESS OF FILM μm

4
3
2
1
0

A ◄—┊—► B

20 18 16 14 12 10 8 6 4 2

POSITION IN REACTOR TUBE
( BY SUSCEPTOR NUMBER )